# EUROPEAN PATENT SPECIFICATION

(11) **EP 1 098 016 B1**
(45) Date of publication and mention of the grant of the patent: **21.05.2008**
(21) Application number: 00917340.2
(22) Date of filing: 18.04.2000
(51) Int. Cl.: C30B 15/00, C30B 29/06

(54) **SINGLE-CRYSTAL PULLING APPARATUS**
EINKRISTALLZIEHVORRICHTUNG
DISPOSITIF DE TIRAGE DU CRISTAL

(30) Priority: 21.04.1999 JP 11333599
(43) Date of publication of application: 09.05.2001
(73) Proprietor: Shin-Etsu Handotai Co., Ltd., Tokyo (JP)
(72) Inventor: NAKAMURA, Yasushi, Nishishirakawa-gun, Fukushima 961-8061 (JP); OTSUKA, Seiichiro, Annaka-shi, Gumma 379-0196 (JP); YOKOTA, Kouzou, Annaka-shi, Gumma 379-0196 (JP)
(74) Representative: Cooper, John
(86) International application number: PCT/JP2000/002520
(87) International publication number: WO 2000/065132

(56) References cited:
- JP-A- 3 295 893
- JP-A- 10 158 091
- US-A- 5 702 522
- US-A- 5 749 967
- KEIGO SENKAWA ED.: 'Bulk kessho seicho gijutsu' 1ST PRINTING, BAIFUKAN 20 May 1994, (TOKYO), page 21, XP002946276

## Description

### Technical Field

The present invention relates to a structure of an apparatus for pulling a single crystal, which is for growing a single crystal ingot by the Czochralski method (CZ method).

### Background Art

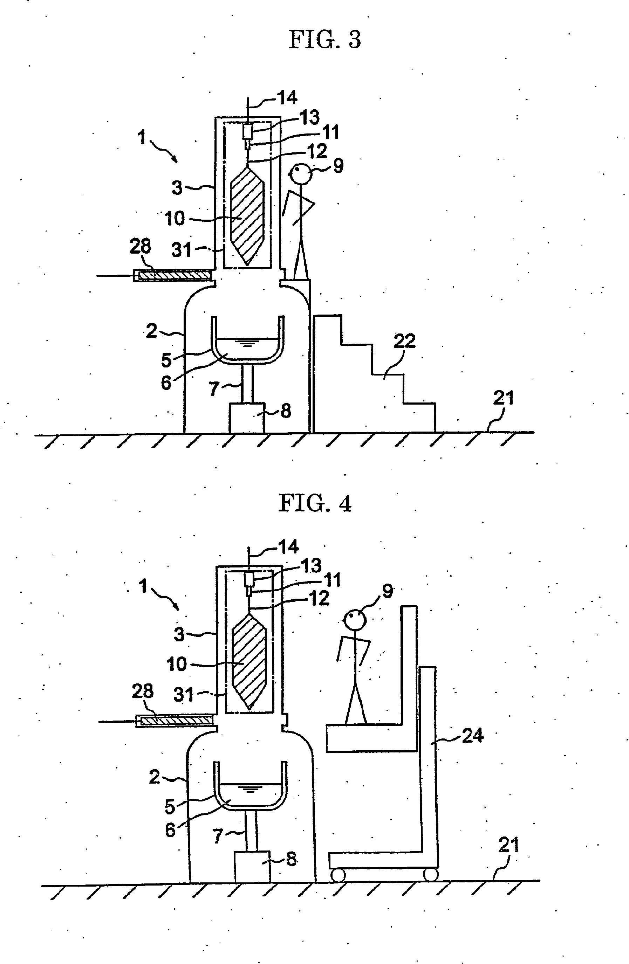

In a conventional apparatus 1 for pulling a single crystal exemplified in Fig. 3, which is based on the Czochralski method and used for the production of single crystals of semiconductors, oxides and so forth, when a single crystal ingot 10 grown up in a main chamber 2 is taken out from the apparatus to the outside, the single crystal ingot 10 is ascended and accommodated into a pull chamber 3, which is set up on the main chamber 2, then a gate valve 28 is closed to separate the pull chamber 3 and the main chamber 2, and cooling of the single crystal ingot 10 is awaited. Then, a door 31 for taking out a single crystal ingot of the pull chamber 3 is opened, and the single crystal ingot is surely held by a non-illustrated single crystal ingot taking out apparatus at its body, and taken out from the apparatus 1 for pulling a single crystal to the outside.

This operation comprises, in order to separate the single crystal ingot 10 from a seed crystal 11 held by a seed holder 13, which is connected to a wire 14, steps of cutting a neck portion 12 with a nipper etc., and transferring the ingot to the single crystal ingot taking out apparatus. These steps are performed by operating personnel 9 by, for example, manually cutting the neck portion with visual confirmation and simultaneously operating the single crystal ingot taking out apparatus and moving parts of mechanisms for up-and-down motion and rotation of single crystal in conformity with the progress of the operation.

Further, in pulling of single crystals using the multi pulling method, in which a plurality of single crystals are pulled from a single crucible, the operation also comprises steps of loading a raw material into the pull chamber 3 and charging an additional raw material into a crucible 5. For taking a container containing the additional raw material or the raw material in and out the pull chamber 3 in the above operation, operational steps similar to those for the taking out the single crystal ingot are performed.

As single crystal ingots recently become heavier and longer, the main chamber 2 and the pull chamber 3 also become larger. Therefore, the operating personnel 9 must engage in the work high above the ground in these days.

In the operation for a conventional large apparatus, the operating personnel 9 may get on the main chamber 2 from a work floor 21 by using a step 22 and perform the separation operation of the single crystal ingot 10 by one hand as shown in Fig. 3, for example. Further, even when an electric lifter 24 as shown in Fig. 4 is used instead of the step 22, the single crystal ingot may be out of the reach of the hand of the operating personnel unless the personnel leans out the lifter and bring the body nearby the pull chamber 3.

Further, the operation of each moving part for taking out the single crystal ingot 10. requires two persons of operating personnel, one of operating personnel 9 who performs visual confirmation on the main chamber 2 or the electric lifter 24, and another operating personnel who operates switches of each moving part on the ground.

Moreover, as for the operation for charging additional raw materials into the pull chamber 3, in pulling of a silicon single crystal, for example, the amount of polycrystal silicon to be charged into the pull chamber at one time has reached 100 kg or more, as the single crystal becomes larger. Therefore, the container containing polycrystal raw material or the raw material rod itself has become very large. For these reasons, safer and more reliable scaffold is required for dealing with such large and heavy objects.

As described above, the operation of separating a single crystal ingot from a large size pulling apparatus, taking out it therefrom, and charging additional raw material are currently performed manually by a plurality of operating personnel. US-A-5 702 522 teaches constructing a growing hall housing a number of crystal pullers. Multilevel floors in the growing hall allow operators to access the pullers at different levels.

### Disclosure of the Invention

Therefore, the present invention has been accomplished in view of these problems observed in the conventional operations, and its main object is to provide an apparatus as set forth in claims 1 and 2 for pulling a single crystal that can further improve safety of operating personnel in the operations in a high position accompanying the production of heavier and longer crystals in operations of, for example, taking out a grown single crystal ingot from an apparatus for pulling a single crystal to the outside or additional charging of raw material from a pull chamber in the multi pulling method, as well as improve reliability of the operations and reduce the labor.

In order to achieve the aforementioned object, the present invention provides an apparatus for pulling a single crystal based on the Czochralski method, wherein the apparatus for pulling a single crystal is provided with an operation deck for carrying out operations in a high position near a main chamber and a pull chamber constituting the single crystal pulling apparatus at a desired position along the height direction.

If the operations of separating a single crystal ingot accommodated in the pull chamber from a seed crystal and taking out it to the outside are performed by using an apparatus for pulling a single crystal constituted as described above, the operating personnel can perform the operations with stable position on the wide operation deck near the single crystal ingot. Therefore, the apparatus for pulling a single crystal can be an apparatus that can improve the reliability of the operations and further improve the safety of the operating personnel.

In this case, it is desirable that the position of the operation deck should correspond to the position of the door of the pull chamber for taking out a single crystal ingot.

If the position of the operation deck corresponds to the position of the door of the pull chamber for taking out a single crystal ingot as described above, for example, the floor of the operation deck corresponds to the lower end of the door of the pull chamber for taking out a single crystal ingot, the operating personnel can most closely approach the single crystal ingot in the operation for separating a single crystal ingot from a seed crystal, and easily use a work tool such as a nipper. Therefore, constrained force is scarcely applied on the single crystal ingot, and the operation of cutting the neck portion can be performed smoothly. Further, manipulation of moving parts of mechanisms for up-and-down motion and rotation of the single crystal and an apparatus for taking out the single crystal ingot can be reliably performed through visual confirmation. Therefore, the apparatus for pulling a single crystal can be an apparatus that can further improve the reliability of the operations and the safety of the operating personnel.

Furthermore, in the apparatus, the operation deck is provided with handy operation switches of remote controllers at least for a mechanism for up-and-down motion and rotation of a single crystal and an apparatus for taking out a single crystal ingot.

This characteristic enables one of operating personnel to carry out the operations of separating a single crystal ingot and taking out it by performing the necessary manipulation of moving parts at hand while confirming by visual confirmation, which was conventionally performed by two of operating personnel in a high position and on the ground by communicating with each other. Therefore, the apparatus for pulling a single crystal can be an apparatus that simultaneously enables more reliable operations and laborsaving.

In the single crystal pulling apparatus based on the CZ method of the present invention, an operation deck is provided near the main chamber and the pull chamber, and a remote controller for manipulating moving parts of the pulling apparatus is provided thereon. Therefore, a position of the operating personnel is more stable and it is possible to perform manual operation as well as remote controlling through visual confirmation near the single crystal ingot. In particular, it can further improve safety of operating personnel in the operations in a high position accompanying the production of heavier and longer crystals in taking out a grown single crystal ingot from an apparatus for pulling a single crystal to the outside, as well as it can improve reliability of the operations and can reduce the labor.

### Brief Explanation of the Drawings

Fig. 1 is a schematic front view of an apparatus for pulling a single crystal of the present invention, which is provided with an operation deck.
Fig. 2 is a schematic plan view of an apparatus for pulling a single crystal of the present invention, which is provided with an operation deck.
Fig. 3 is a schematic explanatory view of a conventional operation of taking out a single crystal ingot by using a step.
Fig. 4 is a schematic explanatory view of a conventional operation of taking out a single crystal ingot by using an electric lifter.

### Best Mode for Carrying out the Invention.

Hereafter, an embodiment of the present invention will be explained mainly for the operation of taking out a single crystal. However, the present invention is not limited to this.

In a conventional apparatus for pulling a single crystal based on the Czochralski method, the operating personnel may take an unstable position for an operation over the main chamber, for example, in the operation of taking out a grown single crystal ingot from the pull chamber. The inventors of the present invention researched and investigated the cause of such a situation, and they found that operations in a high position around the chamber increased with use of a larger chamber accompanying the resent production of heavier and longer crystals. Thus, they accomplished the present invention in order to solve this problem.

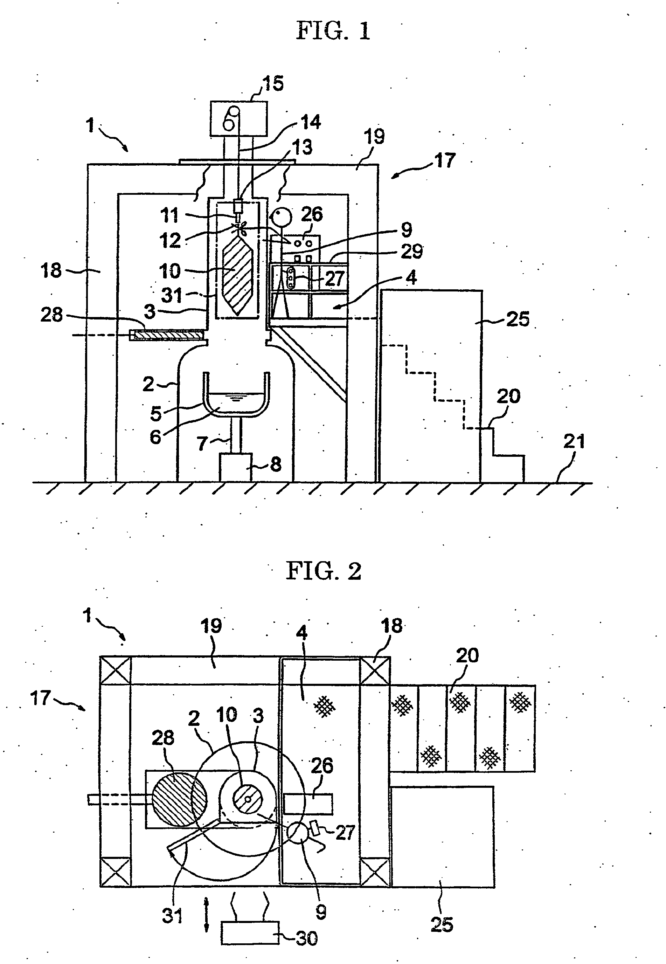

First, an exemplary structure of the apparatus for pulling a single crystal by the CZ method according to the present invention will be explained by referring to the schematic front view and plan view thereof shown in Figs. 1 and 2, respectively.

As shown in Fig. 1, the apparatus 1 for pulling a single crystal comprises a main chamber 2 and a pull chamber 3 set up thereon, and a gate valve 28 for communicating or separating the chambers is provided between the both chambers.

The apparatus further comprises a crucible 5 provided in the main chamber 2, graphite heaters disposed around the crucible 5 (not shown in the figure), a crucible supporting shaft 7 for rotating the crucible 5 and a driving mechanism 8 for up-and-down motion and rotation of the crucible. The crucible 5 consists of an outside graphite crucible and an inside quartz crucible, and silicon melt (molten metal) 6 is accommodated in the inside quartz crucible. A heat insulating material (not shown in the figure) is provided outside the graphite heaters so that it should surround them.

Further, on a work floor 21 where operating personnel performs ordinary operations such as operations for growing crystal, a frame 17 composed of frame pillars 18 and flame beams 19 is provided so that it should surround the chambers 2 and 3, and the frame 17 is installed from an utility floor (not shown in the figure), which is the downstair floor of the work floor 21, and on which incidental equipments for a pulling apparatus is provided. Over the center of frame 17, a mechanism 15 for up-and-down motion and rotation of single crystal for winding and rotating a wire 14 is provided above the pull chamber 3. A silicon seed crystal 11 is held at the lower end of the wire 14 by a seed holder 13.

Further, as shown in Fig. 2, a door 31 for taking out a single crystal ingot is provided on the pull chamber 3, which is provided above the main chamber 2, and an apparatus 30 for taking out a single crystal ingot with an arm for holding a single crystal ingot is disposed near the door 31.

Furthermore, an operation deck 4 is provided near the main chamber 2 and the pull chamber 3 at a desired position along the height direction. In the example shown in Figs. 1 and 2, the position of the operation deck 4 is set to correspond to the position of the door 31 for taking out a single crystal ingot of the pull chamber 3, and the floor face of the operation deck 4 is conformed with the lower end of the door 31.

This operation deck 4 is designed so that it should have a floor area as large as possible, and fixed to the frame 17, and it should not be connected with the both chambers in view of prevention of vibration. Further, a handrail 29 is provided on the circumference of the operation deck 4 for securing safety of operating personnel, and the operating personnel 9 can ascend to and descend from the operation deck 4 through a step 20.

Furthermore, a sub-control panel 26 for the mechanism for up-and-down motion and rotation of a single crystal ingot and the apparatus for taking out a single crystal ingot is provided on the operation deck 4, and a remote controller 27 is always provided on this sub-control panel 26. At the time of the operations of separation and taking out of a single crystal ingot, the operating personnel 9 can carry the remote controller 27 and send operational signals for each driving mechanism by using the handy operational switches while performing manual operations near the single crystal ingot. Therefore, the operations are not required to be performed by two of operating personnel as conventional operations, and can be reliably and accurately performed by one of operating personnel. The main control panel 25 is installed on the work floor 21.

Now, the method for growing a single crystal and the method for taking out it by using the above apparatus 1 for pulling a single crystal based on the CZ method will be explained.

First, a silicon polycrystal raw material of high purity is melted in the crucible 5 by heating it to a temperature higher-than the melting point thereof (about 1420°C). Then, a tip end of the seed crystal 11 held by the seed holder 13 is brought into contact with or immersed into the melt 6 at its approximately center portion by reeling out the wire 14. Then, the crucible supporting shaft 7 is rotated in an appropriate direction, and the seed crystal 11 is simultaneously pulled upwardly by winding up the wire 14 with rotating the wire to start the growing of a single crystal. Thereafter, an approximately columnar single crystal ingot 10 can be obtained by appropriately controlling the pulling rate and temperature.

The grown single crystal ingot 10 is accommodated in the pull chamber 3, and the gate valve 28 is shut to separate from the main chamber 2. After the single crystal ingot is cooled, the door 31 for taking out a single crystal ingot is opened, and the operating personnel 9 manipulates the remote controller 27 on the operation deck 4 to operate the apparatus 30 for taking out a single crystal ingot, so that the body of the single crystal ingot 10 should be held by the apparatus. Then, the operating personnel 9 cuts a neck portion 12 with a nipper to separate the single crystal ingot 10 from the seed crystal 11 Thereafter, the single crystal ingot 10 is taken out from the pull chamber 3 by operating the apparatus 30 for taking out a single crystal ingot, transferred to an appropriate place and stored.

As explained above, in the embodiment of the present invention, an operation deck is provided near the main chamber and the pull chamber constituting an apparatus for pulling a single crystal at a desired position along the height direction. Therefore, in the operation of separating a single crystal ingot from a seed crystal, the operating personnel can most closely approach the single crystal ingot and therefore the operating personnel can easily use a work tool. Thus, the reliability of the operations is improved. Further, the manipulation of the arm of the apparatus for taking out a single crystal ingot can be surely performed with visual confirmation, and therefore accurate operations can be realized and safety of operating personnel can be further improved. Furthermore, laborsaving is also possible.

Moreover, because handy operational switches of remote controller for the mechanism for up-and-down motion and rotation of single crystal and the apparatus for taking out a single crystal ingot are provided on the operation deck, the operations of separating a single crystal ingot and taking out it can be performed by one of operating personnel by manipulating the switches of the remote controller at hand while confirming by visual confirmation, which operations were conventionally performed by two of operating personnel in a high position and on the ground by communicating with each other. Therefore, further reliable operations become possible and accuracy of the operations and safety of operating personnel can further be improved.

The present invention is not limited to the embodiment described above. The above-described embodiment is a mere example, and those having the substantially same structure as that described in the appended claims and providing the similar functions and advantages are included in the scope of the present invention.

For example, in the aforementioned embodiment, the operation deck was explained to be fixed on the frame. However, the present invention is not limited to this, and it may be provided in various forms. For example, it may be set up from the work floor, or it may be provided on the chamber.

Further, in the aforementioned embodiment, although the position of the operation deck was set to correspond to the door of the pull chamber, it may be provided at an arbitrary height depending on the purpose. For example, when the pull chamber is a bellows chamber, the position may be changed to a position of a suitable height. Further, the operation to be performed is not limited to the taking out of the crystal, and when exchange of the seed crystal or seed holder or the like is performed, the height of the position may be changed.

Moreover, while the foregoing explanation was given mainly on the case where a silicon single crystal is pulled by the apparatus of the present invention, the present invention is not limited to this. It can of course be used as an apparatus for pulling compound semiconductors such as GaAs and GaP, oxide single crystals and so forth.

Furthermore, although the effects of the apparatus of the present invention were explained mainly for the operation of taking out a single crystal ingot, it can also be satisfactorily used for, for example, setting or taking out of a raw material container containing a polycrystal raw material into or from the pull chamber in the additional charging of the raw material in the multi pulling method and so forth.

## Claims

1. An apparatus (1) for pulling a single crystal based on the Czochralski method, wherein the apparatus (1) comprises a main chamber (2) and a pull chamber (3), and the apparatus (1) is provided with an operation deck (4) for carrying out operations in a high position along the height direction corresponding to a position of a door (31) of the pull chamber (3) for taking out a single crystal ingot; **characterised in that** there are provided on this operation deck handy operation switches of sub-control panel and remote controller (26,27) for controlling up-and-down motion and rotation of a single crystal in the apparatus (1) and for controlling an apparatus (30) for taking out single crystal ingot.

2. An apparatus (1) according to claim 1, in which said handy operation switches are provided on a remote controller (27) which can be carried by operating personnel (9) while performing manual operations near the single crystal ingot.

## Patentansprüche

1. Eine Vorrichtung (1) zum Ziehen eines Einkristalls auf der Basis des Czochralski-Verfahrens, wobei die Vorrichtung (1) eine Hauptkammer (2) und eine Ziehkammer (3) beinhaltet und die Vorrichtung (1) mit einer Arbeitsplattform (4) versehen ist, um Arbeitsabläufe in einer hohen Position entlang der Höhenrichtung, die einer Position einer Tür (31) der Ziehkammer (3) zum Entnehmen eines Einkristallrohlings entspricht, auszuführen; **dadurch gekennzeichnet, dass** auf dieser Arbeitsplattform handliche Arbeitsschalter eines **Hilfssteuerpults und einer Fernsteuerung (26, 27) bereitgestellt** sind, um die Auf- und Abbewegung und die Drehung eines **Einkristalls in der Vorrichtung (1) zu steuern und um eine** Vorrichtung (30) zum Entnehmen eines Einkristallrohlings zu steuern.

2. Vorrichtung (1) gemäß Anspruch 1, bei der die handlichen Arbeitsschalter auf einer Fernsteuerung (27) bereitgestellt sind, die von Betriebspersonal (9) getragen werden kann, während manuelle Arbeitsabläufe nahe dem Einkristallrohling durchgeführt werden.

## Revendications

1. Un appareil (1) pour tirer un monocristal basé sur la méthode de Czochralski, dans lequel l'appareil (1) comprend une chambre principale (2) et une chambre de tirage (3), et l'appareil (1) est muni d'une passerelle d'opérations (4) destinée à l'exécution d'opérations à une position élevée dans le sens de la hauteur correspondant à une position d'une porte (31) de la chambre de tirage (3) destinée à sortir un lingot de monocristal ; **caractérisé en ce que** sont fournis sur cette passerelle d'opérations des commutateurs d'opérations pratiques de panneau de sous-contrôle et de commande à distance (26, 27) destinés à commander les mouvements vers le haut et vers le bas et la rotation d'un monocristal dans l'appareil (1) et à commander un appareil (30) destiné à sortir un lingot de monocristal.

2. Un appareil (1) selon la revendication 1, dans lequel lesdits commutateurs d'opérations pratiques sont prévus sur une commande à distance (27) qui peut être transportée par l'opérateur (9) alors qu'il effectue des opérations manuelles près du lingot de monocristal.
